# EUROPÄISCHE PATENTSCHRIFT

(11) **EP 2 580 858 B1**
(45) Veröffentlichungstag und Bekanntmachung des Hinweises auf die Patenterteilung: **11.12.2019**
(21) Anmeldenummer: 11724233.9
(22) Anmeldetag: 09.06.2011
(51) Int. Cl.: H02M 7/487

(54) **SCHALTUNGSTOPOLOGIE FÜR EINEN PHASENANSCHLUSS EINES WECHSELRICHTERS**
CIRCUIT TOPOLOGY FOR A PHASE CONNECTION OF AN INVERTER
TOPOLOGIE DE CIRCUIT POUR CONNEXION DE PHASE D'UN ONDULEUR

(30) Priorität: 12.06.2010 DE 102010023601
(43) Veröffentlichungstag der Anmeldung: 17.04.2013
(73) Patentinhaber: Kostal Industrie Elektrik GmbH, 58513 Lüdenscheid (DE)
(72) Erfinder: DEGENER, Martin, 44795 Bochum (DE); KRETSCHMANN, Michael, 58093 Hagen (DE)
(74) Vertreter: Kerkmann, Detlef
(86) Internationale Anmeldenummer: PCT/EP2011/059627
(87) Internationale Veröffentlichungsnummer: WO 2011/154506

(56) Entgegenhaltungen:
- JP-A- 2002 247 862
- US-A1- 2010 039 843
- MICHAEL FRISCH, TEMESI ERNÖ: "Innovative Topologies for High Efficient Solar Applications", POWER ELECTRONICS EUROPE, 30. März 2009 (2009-03-30), Seiten 32-33, XP002675203, Gefunden im Internet: URL:http://www.power-mag.com/pdf/issuearch ive/28.pdf [gefunden am 2012-05-03]
- KAMINSKI B ET AL: "A three level inverter concept for low voltage applications", EUROPEAN CONFERENCE ON POWER ELECTRONICS AND APPLICATIONS, EPE-2007, 2007, XP002675204, INST. OF ELEC. AND ELEC. ENG. COMPUTER SOCIETY US DOI: 10.1109/EPE.2007.4417726

## Beschreibung

Die vorliegende Erfindung betrifft eine Schaltungstopologie für einen Phasenanschluss eines Wechselrichters mit einer Schaltungsbrücke, deren Brückenausgang über jeweils eine zumindest zwei in Reihe geschaltete erste Leistungsschalter umfassende obere und untere Halbbrückenhälfte mit zumindest einem oberen und einem unteren Grenzpotential, sowie über jeweils eine Diode und einen mit dieser in Reihe geschalteten ersten Leistungsschalter der oberen oder unteren Halbbrückenhälfte mit einem zwischen dem oberen und einem unteren Grenzpotential gelegenen Mittenpotential verbindbar ist, sowie ein Verfahren zum Erzeugen einer Phasenausgangsspannung eines Wechselrichters mit einer solchen Schaltungstopologie.

Wechselrichter dienen dazu, eine elektrische Gleichspannung in eine ein- oder mehrphasige Wechselspannung umzuwandeln. Sie kommen z.B. bei Anwendungen im Bereich der Photovoltaik zum Einsatz, wo eine durch Solarzellen erzeugte Gleichspannung in eine Wechselspannung für das öffentliche Stromnetz umgewandelt wird.

Ein weiteres Anwendungsgebiet für Wechselrichter stellt der Betrieb von Elektromotoren, insbesondere von Asynchronmaschinen dar, wobei der Wechselrichter als Bestandteil so genannter Frequenzumrichter eingesetzt wird, die eine Netzwechselspannung in eine Antriebswechselspannung höherer Frequenz und Amplitude umwandeln. Heutzutage werden nahezu alle Frequenzumrichter als Umrichter mit konstanter Zwischenkreisspannung ausgeführt. Dabei wird die netzseitige Eingangsspannung mit Hilfe eines Gleichrichters in eine Gleichspannung umgewandelt, die mit Hilfe von Kondensatoren geglättet wird.

Es existiert eine Vielzahl von Schaltungstopologien, mit deren Hilfe aus einer Gleichspannung eine Wechselspannung erzeugt werden kann, wobei es grundsätzlich gleich ist, ob es sich dabei um eine originäre Gleichspannung, beispielsweise aus einem Solarmodul handelt oder um die gleichgerichtete Zwischenkreisspannung eines Frequenzumrichters.

Gemeinsam ist all diesen Schaltungstopologien das Prinzip, dass durch ein getaktetes Öffnen und Schließen elektronischer Leistungsschalter, der Ausgang des Wechselrichters mit unterschiedlichen Potentialen verbunden und so eine Wechselspannung gewünschter Frequenz erzeugt wird.

Eine wichtige Kennzahl zur Charakterisierung der Qualität von Wechselrichtern ist ihr so genannter Wirkungsgrad. Mit diesem wird das Verhältnis von abgegebener Leistung oder Nutzleistung zu zugeführter Leistung angegeben, das möglichst hoch sein sollte.

Ein wesentlicher Faktor zur Begrenzung des erreichbaren Wirkungsgrades liegt in den Verlusten, die in den verwendeten Bauteilen, insbesondere in den elektronischen Leistungsschaltern auftreten. Dabei spielen in diesen Schaltern zwei relevante Verlustmechanismen eine Rolle, die durch eine Vielzahl von Faktoren beeinflusst werden, von denen im Folgenden nur die wichtigsten genannt werden.

Der erste Verlustmechanismus sind die Schaltverluste, die im Moment des Öffnens und Schließens des Schalters auftreten. Diese nehmen ganz allgemein bei allen Leistungsschaltern proportional mit der verwendeten Schaltfrequenz zu. Bei gegebener Schaltfrequenz erzeugen solche Schalter, die eine höhere Spannungsfestigkeit aufweisen, also zum Schalten höherer Spannungen geeignet sind, deutlich höhere Schaltverluste als Schalter mit geringerer Spannungsfestigkeit.

Der zweite wichtige Verlustmechanismus sind die Durchlassverluste, die im leitenden Zustand des Schalters auftreten. Diese sind proportional zu dem als Sättigungsspannung bezeichneten Spannungsabfall über dem Schalter im leitenden Zustand. Diese Sättigungsspannung nimmt nur in einem sehr geringen Maße mit der Spannungsfestigkeit des Schalters zu und hängt neben der Spannungsfestigkeit des Schalters auch noch von anderen Faktoren ab, so dass die Durchlassverluste als nur bedingt von der Spannungsfestigkeit des Schalters abhängig anzusehen sind.

Da diese beiden Verslustmechanismen in unterschiedlichen Schaltungstopologien ein unterschiedliches Gewicht haben, bieten die Hersteller der zu diesen Zwecken eingesetzten Halbleiterschalter, wie z.B. MOSFETs oder IGBTs entsprechende Komponenten mit verschiedenen Eigenschaften an. So gibt es zum einen Schalter, die zur Erreichung geringer Schaltverluste optimiert sind und dafür eine etwas höhere Sättigungsspannung haben, zum anderen aber auch solche, die zur Erzielung einer geringen Sättigungsspannung optimiert sind und dafür etwas höhere Schaltverluste aufweisen.

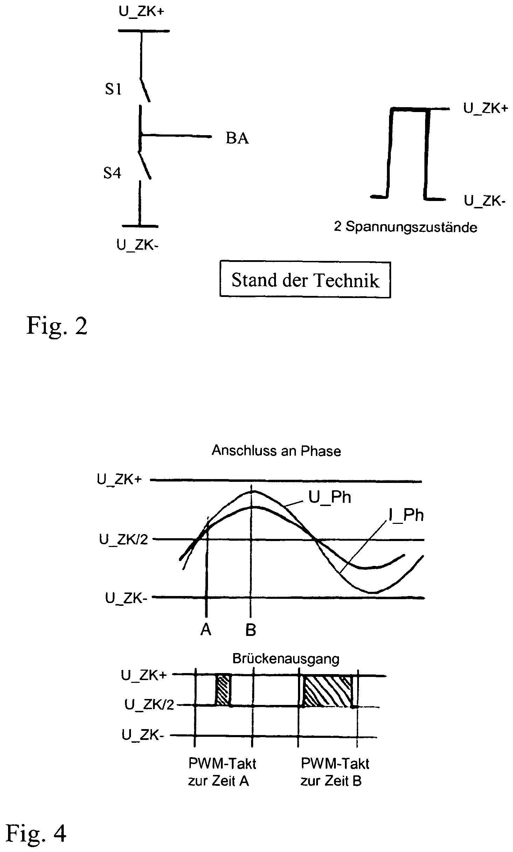

Eine standardmäßig verwendete Schaltungstopologie ist die in Fig. 2 gezeigte 2-Level-Halbbrücke, welche aus zwei Leistungsschaltern S1, S4 je Phase besteht; dargestellt ist hier, wie auch in den weiteren Beispielen, jeweils nur eine Phase. Bei dieser Topologie wird der Brückenausgang BA abwechselnd durch den Schalter S1 mit dem oberen Gleichspannungspotential U_ZK+ und durch den Schalter S4 mit dem unteren Gleichspannungspotential U_ZK- verbunden. Für das Schalten über den kompletten Spannungshub kommen als Schalter S1, S4 nur solche mit hoher Spannungsfestigkeit in Frage und es entstehen bei gegebener Frequenz relativ große Schaltverluste. Allgemein kann man sagen, das hiermit in typischen Wechsel- und Umrichteranwendungen die Schaltverluste dominant sind.

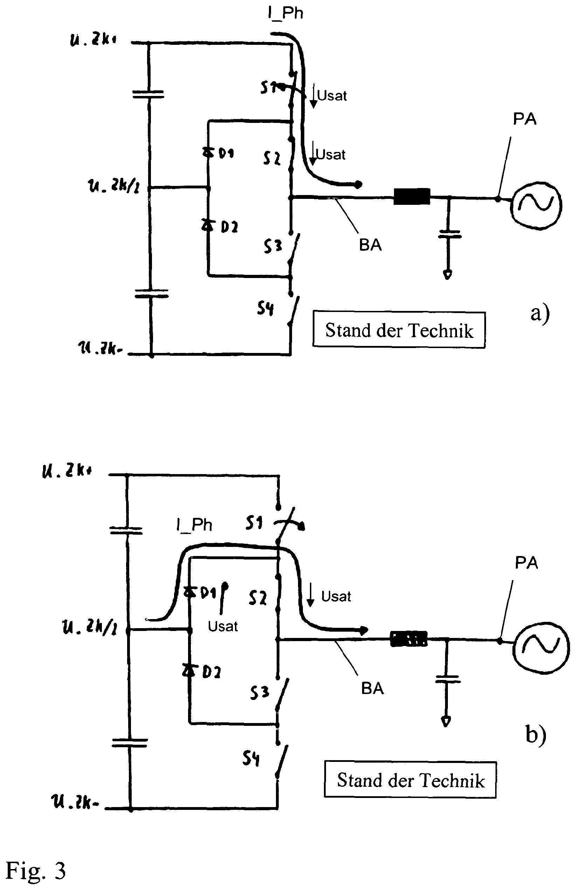

Eine andere, bekannte Schaltungstopologie ist die Multi-Level-Topologie, deren einfachste und gebräuchlichste Ausführung die in Fig. 3 gezeigte "Neutralpoint Point Clamped" 3-Level-Topologie ist. Diese 3-Level-Topologie besteht aus 4 Leistungsschaltern S1, S2, S3, S4 je Phase und zwei Dioden D1, D2. Da die Spannungshübe beim Umschalten eines einzelnen Schalters hierbei immer nur der Hälfte des Gesamt-Spannungshubes U_ZK+ - U_ZK- entsprechen, können Leistungsschalter zum Einsatz kommen, welche im Vergleich zu der zuvor beschriebenen 2-Level-Halbbrücken Topologie bei gleichem Gesamt-Spannungshub nur die halbe Spannungsfestigkeit aufweisen müssen. Da diese Leistungsschalter, wie eingangs dargelegt, bei gegebener Frequenz im allgemeinen deutlich geringere Schaltverluste verursachen als spannungsfestere Schalter, sind auch die gesamten Schaltverluste dieser Schaltungstopologie geringer als die der 2-Level-Halbbrücken Topologie. Im Unterschied zu dieser werden jedoch im leitenden Zustand der Leistungsschalter zu jeder Zeit mindestens zwei Halbleiter durchflossen und zwar entweder zwei Leistungsschalter, also z.B. die Schalter S1 und S2, oder ein Leistungsschalter und eine Diode, also z.B. Schalter S2 und Diode D1. Dadurch sind bei dieser Topologie die Durchlassverluste größer als bei einer 2-Level-Topologie. Allgemein kann man sagen, das in typischen Wechsel- und Umrichteranwendungen bei der 3-Level-Topologie die Durchlassverluste dominant sind.

Bei gleicher Verlustleistung erlaubt die Multilevel-Topologie den Betrieb bei höheren Schaltfrequenzen als die 2-Level-Topologie, was gleich mehrere Vorteile hat. So können zum einen kleinere und kostengünstigere passive Komponenten verwendet werden, die wiederum einen geringeren Bauraum benötigen, zum anderen lässt sich aber auch eine geringere Welligkeit der Ausgangsspannung erreichen. Aufgrund solcher Faktoren kommen trotz der erwähnten Begrenzung des Wirkungsgrades durch die Durchlassverluste immer öfter Multilevel-Topologien zum Einsatz.

Der Fachartikel "Innovative Topologies for High Efficient Solar Applications" von Michael Frisch und Temesi Ernö in "Power Electronics Europe", Ausgabe 3, 2009 offenbart eine Schaltungstopologie gemäß dem Oberbegriff des Patentanspruchs 1, bei der zusätzlich zu den üblichen Komponenten einer solchen Schaltungstopologie jeweils ein weiterer Leistungsschalter zu einem der ersten Leistungsschalter parallel geschaltet ist.

Bei der Schaltungstopologie gemäß der vorliegenden Erfindung sind die Durchlassverluste bei Multilevel-Topologien gegenüber dem vorbekannten Stand der Technik deutlich reduziert. Die erfindungsgemäße neue Topologie ist sowohl für die beschriebene 3-Level-Konfiguration, als auch für Multilevel-Topologien höherer Ordnung anwendbar und erhöht maßgeblich deren Wirkungsgrad.

Dies wird erfindungsgemäß dadurch erreicht, dass die obere und die untere Halbbrückenhälfte jeweils einen weiteren, zweiten Leistungsschalter umfassen, der jeweils zu der Reihenschaltung der ersten Leistungsschalter parallel geschaltet ist.

Bei Multilevel-Topologien höherer Ordnung umfasst die Schaltungsbrücke weitere erste Leistungsschalter und Dioden, über die der Brückenausgang mit weiteren, zwischen dem Mittenpotential und dem oberen und unteren Grenzpotential gelegenen Zwischenpotentialen verbindbar ist.

Eine noch weitergehende Reduzierung der Verluste der Schaltung und damit eine Erhöhung des Wirkungsgrades des Wechselrichters wird dadurch erreicht, dass die in Reihe geschalteten ersten Leistungsschalter zur Erzielung möglichst geringer Schaltverluste ausgelegt sind, und dass die jeweils zu der Reihenschaltung der ersten Leistungsschalter parallel geschalteten zweiten Leistungsschalter zur Erzielung möglichst geringer Sättigungsspannungen ausgelegt sind.

Besonders bevorzugt wird die erfindungsgemäße Schaltungstopologie zur Durchführung des ebenfalls erfindungsgemäßen Verfahrens gemäß Patentanspruch 4 eingesetzt.

Weitere vorteilhafte Ausgestaltungen und Weiterbildungen der erfindungsgemäßen Schaltungstopologie sowie des erfindungsgemäßen Verfahrens ergeben sich aus den jeweiligen Unteransprüchen und werden anhand der Zeichnung erläutert.

Es zeigen:
- Figur 1: Ein Prinzipschaltbild einer erfindungsgemäßen Schaltungstopologie, in einer Ausführung als 3-Level-Topologie zu zwei unterschiedlichen Schaltzeitpunkten a) und b) beim Schließen der oberen Halbbrückenhälfte sowie zu zwei unterschiedlichen Schaltzeitpunkten c) und d) beim Öffnen der oberen Halbbrückenhälfte
- Figur 2: Ein Prinzipschaltbild einer 2-Level Halbbrücke gemäß dem Stand der Technik
- Figur 3: Ein Prinzipschaltbild einer 3-Level-Topologie gemäß dem Stand der Technik zu zwei unterschiedlichen Schaltzeitpunkten a) beim Schließen und b) beim Öffnen der oberen Halbbrückenhälfte
- Figur 4: Eine Darstellung des Zusammenahngs zwischen Phasenspannung, Spannung am Brückenausgang und PWM-Verhältnis Ein-Aus bei der Topologie gemäß Fig. 3

Zur Erläuterung der Funktion der erfindungsgemäßen Schaltungstopologie und der damit erzielten Vorteile wird zunächst noch einmal anhand der Fig. 3a und 3b die Funktion der konventionellen Neutral Point Clamped 3L Brücke erläutert. Ohne dass dies eine Beschränkung auf die Anwendung bei einem Frequenzumrichter darstellen soll, wird dabei zum Zwecke der besseren Unterscheidbarkeit im folgenden die Eingangsgleichspannung der Brückenschaltung, wie bei einer solchen Anwendung üblich, als Zwischenkreisspannung bezeichnet. Es reicht für die nachfolgenden Erläuterungen aus, einen einzelnen Schalttakt, d.h. das Öffnen und Schließen einer Halbbrückehälfte, zu betrachten. In dem folgendem Beispiel soll sich das Potential der sinusförmigen Phasen- oder Netzspannung U_Ph, die an dem über einen durch eine Drossel L und einen Kondensator C gebildeten Filter mit dem Brückenausgang BA verbundenen Phasenanschluss PA anliegt, immer oberhalb des Mittenpotentials, oder anders ausgedrückt der halben Zwischenkreisspannung U_ZK/2 befinden. Damit schalten in der 3L Brücke nur die beiden oberen Schalter S1 und S2. In der Regel wird am Ausgang BA der Brücke ein pulsweitenmoduliertes oder PWM-Signal ausgegeben. Das Pulsweiten-Verhältnis, also das Verhältnis zwischen "An-Zeit", in der die obere Zwischenkreisspannung U_ZK+ am Ausgang BA anliegt, und "Aus-Zeit", in der die halbe Zwischenkreisspannung U_ZK/2 am Ausgang BA anliegt, ist dabei in etwa proportional der momentanen Phasenspannung U_Ph.

Fig. 4 zeigt exemplarisch an der oberen Sinushalbwelle, wie sich das PWM-Verhältnis mit der Phasenspannung U_Ph ändert. Zum Zeitpunkt A, zu dem die Phasenspannung nur wenig oberhalb der halben Zwischenkreisspannung U_ZK/2 liegt, ist die An-Zeit deutlich kürzer als die Aus-Zeit, zum Zeitpunkt B, zu dem die Phasenspannung ihr Maximum erreicht, kehrt sich dieses Verhältnis gerade um. Beim Einsatz in Wechselrichtern und ähnlichen Anwendungen ist zudem der Phasenstrom I_Ph im Idealfall in Phase mit der Phasenspannung U_Ph.
Der Schalter S2 ist für den gesamten Zeitraum, in dem die Phasenspannung U_Ph größer als die halbe Zwischenkreisspannung U_ZK/2 ist, geschlossen, also leitend. Wie in Fig. 3a, die den Beginn der An-Zeit der PWM-Periode zeigt, schliesst der Schalter S1, und die Ausgangsspannung am Brückenausgang BA entspricht U_ZK+. Durch das Schliessen des Schalters S1 entsteht der Einschalt-Schaltverlust PSchalt_ein. Im geschlossenen Zustand fliesst der Phasenstrom I_Ph über die beiden Schalter S1 und S2. Dabei fällt an S1 und S2 jeweils die Sättigungsspannung Usat ab, für welche hier zum Zwecke einer Beispielrechnung ebenso wie für die Diode D1 ein typischer Wert von 1,5 Volt angenommen wird.

In Fig. 3b, die den Zeitpunkt nach Ablauf der An-Zeit der PWM-Periode zeigt, öffnet sich der Schalter S1 wieder. Es kommt zum Ausschalt-Schaltverlust PSchalt_aus. Anschliessend fliesst der Strom I_Ph über die Diode D1 und den Schalter S2, wobei an beiden Bauelementen jeweils die Sättigungsspannung Usat anliegt. Die Summe der Verluste ergibt sich aus den Schaltverlusten PSchalt_ein und PSchalt_aus und der Sättigungsspannung Usat multipliziert mit dem Phasenstrom I_Ph. Nimmt man für die vorliegende Beispielrechnung einen Effektivstrom von I_Ph = 100 Ampere an, so ergibt sich in grober Näherung während der An-Zeit aufgrund der angenommenen Sättigungsspannung von Usat_ = 1,5 Volt eine Durchlass-Verlustleistung von P_DV = 100 A*1,5 V*2 = 300 Watt.

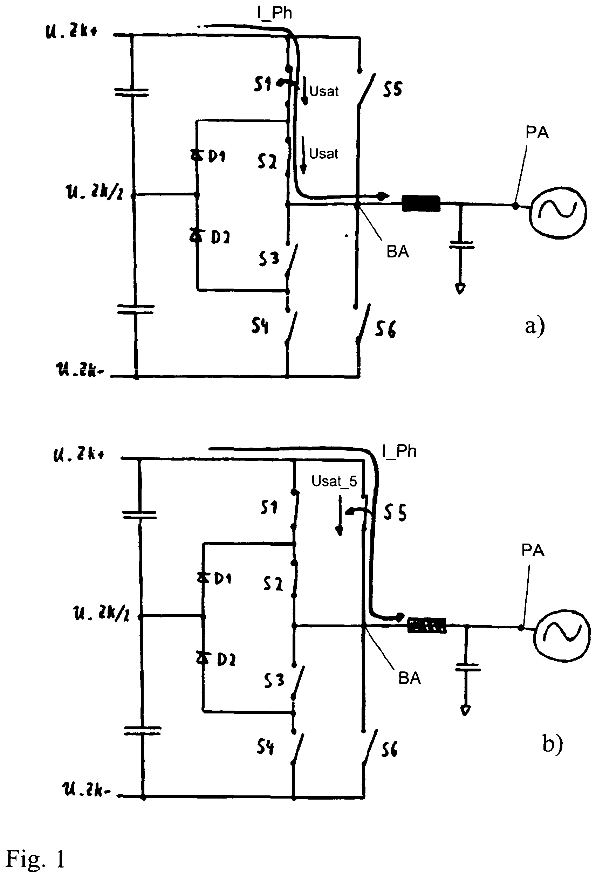

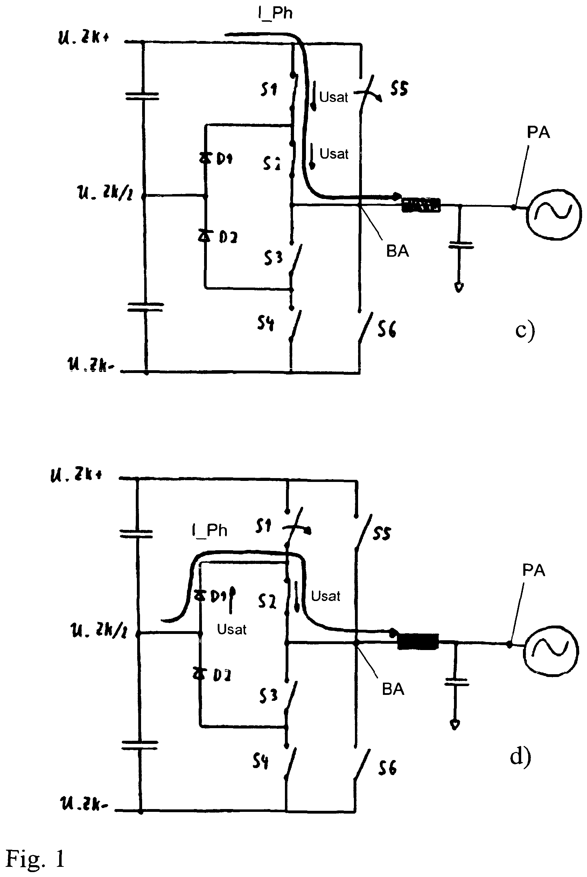

Die Fig. 1 a) bis 1 d) zeigen die Funktion der erfindungsgemäßen Schaltung. Auch hier wird, wie in dem vorangegangenen Beispiel, nur ein einzelner Schalttakt, d.h. das Öffnen und Schließen einer Halbbrückenhälfte, betrachtet. Während dieses Zeitraums befindet sich das Potential der sinusförmigen Phasen- oder Netzspannung U_Ph immer oberhalb des Mittenpotentials U_ZK/2 der halben Zwischenkreisspannung, und der Schalter S2 ist während des gesamten Zeitraums geschlossen. Wie in Fig. 1 a) zu sehen, schliesst zu Beginn der An-Zeit der Schalter S1, und die Ausgangsspannung am Brückenausgang entspricht U_ZK+. Durch das Schliessen entsteht der Einschalt-Schaltverlust PSchalt_ein. Im geschlossenen Zustand fliesst der Strom I_Ph zuerst über die beiden Schalter S1 und S2. Nach einer gegenüber der gesamten An-Zeit sehr kurzen Verzögerungszeit schliesst, wie in Fig. 1 b) dargestellt, zusätzlich der zu der Reihenschaltung von S1 und S2 parallele Schalter S5. Über dem Schalter S5 liegt unmittelbar vor dem Einschalten nur eine sehr geringe Spannung an, nämlich die Summe der Sättigungsspannungen der Schalter S1 und S2, also mit den in dem hier vorgestellten Beispiel verwendeten Werten eine Spannung von 3 Volt, so dass beim Einschalten des Schalters S5 keine relevanten Schaltverluste entstehen. Der Strom I_Ph fliesst danach hauptsächlich über den Schalter S5, dessen Sättigungsspannung Usat_5 hier exemplarisch mit 2 Volt angegeben ist.

Kurz vor Ablauf der Ein-Zeit öffnet der Schalter S5 wieder, wie in Fig. 1 c) dargestellt. Da nach dem Öffnen des Schalters S5 der Phasenstrom I_Ph wieder durch die Reihenschaltung der nach wie vor geschlossenen Schalter S1 und S2 getragen wird, liegt über S5 auch dann nur eine geringe Spannung an, so dass auch bei dem Ausschaltvorgang wieder keine relevanten Schaltverluste auftreten. Kurz nach dem Schalter S5 öffnet auch der Schalter S1 zum Ende der Ein-Zeit und anschliessend fliesst der Phasenstrom I_Ph über die Diode D1 und den Schalter S2, wie dies in Fig. 1 d) gezeigt ist. Beim Ausschalten des Schalters S1 entsteht der Ausschalt-Schaltverlust PSchalt_aus.

Mit dem in diesem Beispiel angenommenen Effektivstrom von I_Ph = 100 A ergibt sich nun in grober Näherung während der An-Zeit eine Durchlass-Verlustleistung von P_DV = 100 A*2 V*1 = 200 Watt aufgrund der angenommenen Sättigungsspannung des Schalters S5 von Usat_5 = 2 Volt.

Die bei dieser neuen Schaltung auftretenden Schaltverluste sind identisch mit den bei der zuvor beschriebenen, konventionellen 3L-Topologie auftretenden. Durch den Einsatz der Eingangs erwähnten Schalter der Ausprägung, dass bei diesen die Schaltverluste zu Lasten einer höheren Sättigungsspannung verringert sind, für die Reihenschaltung von S1 und S2 können diese Verluste sogar noch gesenkt werden. Der Nachteil der höheren Sättigungsspannung dieser Schalter S1 und S2 wirkt sich wegen des im wesentlichen durch den parallelen Schalter S5 getragenen Stromes nicht negativ aus. Der Schalter S5 wiederum hat idealerweise die genau gegenteilige Ausprägung, nämlich eine möglichst geringe Sättigungsspannung ohne Rücksicht auf seine möglichen Schaltverluste, die ja in der neuen Schaltung keine Rolle spielen.

Die Durchlass-Verluste aufgrund der Sättigungsspannung, welche bei niedrigen und mittleren Taktfrequenzen bei Multi-Level-Topologien dominierend sind, können mit der neuartigen Topologie während der PWM-An-Zeit deutlich gesenkt werden. Da die Verluste durch die Sättigungsspannung proportional zum Strom sind, der Strom in vielen typischen Anwendungen etwa phasengleich zur Spannung ist, und bei hohen Spannungen die PWM-An-Zeit groß ist im Verhältnis zur PWM-Aus-Zeit, reduziert diese neue Schaltung die gesamten Durchlassverluste in ganz erheblichem Maße.

## Patentansprüche

1. Schaltungstopologie für einen Phasenanschluss (PA) eines Wechselrichters mit einer Schaltungsbrücke, deren Brückenausgang (BA) über jeweils eine zumindest zwei in Reihe geschaltete erste Leistungsschalter (S1, S2; S3, S4) umfassende obere und untere Halbbrückenhälfte mit zumindest einem oberen (U_ZK+) und einem unteren Grenzpotential (U_ZK-), sowie über jeweils eine Diode (D1, D2) und einen mit dieser in Reihe geschalteten ersten Leistungsschalter (S2, S3) der oberen oder unteren Halbbrückenhälfte mit einem zwischen dem oberen und einem unteren Grenzpotential gelegenen Mittenpotential (U_ZK/2) verbindbar ist, **dadurch gekennzeichnet, dass** die obere und die untere Halbbrückenhälfte jeweils einen weiteren, zweiten Leistungsschalter (S5, S6) umfassen, der jeweils zu der Reihenschaltung der ersten Leistungsschalter (S1, S2; S3, S4) parallel geschaltet ist.

2. Schaltungstopologie nach Anspruch 1, **dadurch gekennzeichnet, dass** die Schaltungsbrücke weitere erste Leistungsschalter und Dioden umfasst, über die der Brückenausgang (BA) mit weiteren, zwischen dem Mittenpotential (U_ZK/2) und dem oberen (U_ZK+) und unteren Grenzpotential (U_ZK-) gelegenen Zwischenpotentialen verbindbar ist.

3. Schaltungstopologie nach Anspruch 1 oder 2, **dadurch gekennzeichnet, dass** die in Reihe geschalteten ersten Leistungsschalter (S1, S2; S3, S4) zur Erzielung möglichst geringer Schaltverluste ausgelegt sind, und dass die jeweils zu der Reihenschaltung der ersten Leistungsschalter (S1, S2; S3, S4) parallel geschalteten zweiten Leistungsschalter (S5, S6) zur Erzielung möglichst geringer Sättigungsspannungen ausgelegt sind.

4. Verfahren zum Erzeugen einer Phasenausgangsspannung eines Wechselrichters mit einer Schaltungstopologie nach einem der vorhergehenden Ansprüche, wobei der Ablauf eines Schalttaktes, an dessen Beginn und Ende der Brückenausgang (BA) jeweils über eine Diode (D1, D2) und einen mit dieser in Reihe geschalteten ersten Leistungsschalter (S2, S3) mit dem Mittenpotential (U_ZK/2) verbunden ist, **gekennzeichnet ist durch** die Verfahrensschritte:
- Schließen des mit dem bereits geschlossenen ersten Leistungsschalter (S2, S3) in Reihe geschalteten weiteren ersten Leistungsschalters (S1, S4)
- Schließen des zu den geschlossenen ersten Leistungsschaltern (S1, S2; S3, S4) parallel geschalteten zweiten Leistungsschalters (S5, S6) nach einer gegenüber der Dauer des Schalttaktes kurzen Verzögerungszeit
- Öffnen des zu den geschlossenen ersten Leistungsschaltern (S1, S2; S3, S4) parallel geschalteten zweiten Leistungsschalters (S5, S6) kurz vor dem Ablauf der Dauer des Schalttaktes
- Öffnen des mit dem den Brückenausgang (BA) mit dem Mittenpotential (U_ZK/2) verbindenden ersten Leistungsschalter (S2, S3) in Reihe geschalteten weiteren ersten Leistungsschalters (S1, S4) nach einer gegenüber der Dauer des Schalttaktes kurzen Verzögerungszeit

## Claims

1. Switching topology for a phase connection (PA) for an inverter with a switching bridge, the output (BA) of which can be connected to a centre potential (U_ZK/2) located between the upper and a lower limit potential via at least two upper and lower half-bridges consisting of initial power switches (S1, S2; S3, S4) with at least one upper (U_ZK+) and one lower limit potential (U_ZK-) as well as via a diode (D1, D2) and an initial power switch (S2, S3) in the upper or lower half of the bridge switched in series with it, **characterized by the fact that** the upper and the lower halves of the bridge each consist of another, second power switch (S5, S6) which is switched in parallel with the series switching arrangement of the first power switches (S1, S2; S3, S4).

2. Switching topology as in Claim 1, **characterized by** the fact that the switching bridge contains further initial power switches and diodes, via which the bridge output (BA) can be connected with further intermediate potentials located between the centre potential (U_ZK/2) and the upper limit potential (U_ZK+) and the lower limit potential (U_ZK-).

3. Switching topology as in Claim 1 or Claim 2, **characterized by** the fact that the initial power switches (S12, S2, S3, S4) switches in series are designed to achieve the lowest possible switching loss and that the second power switches (5, S6) switched in parallel with the in series switching power switches (S1, S2; S3, S4) are designed to achieve the lowest possible saturation voltages.

4. A procedure to generate a phase output voltage of an inverter with a switching topology as described in one of the above claims, whereby the operation of a switching pulse, at the beginning and end of which the bridge output (BA) is connected to the centre potential (U_ZK/2) via a diode (D1, D2) and an initial power switch (S2, S3) switched in parallel with it, **characterized by** the procedural stages:
- closing in series of the further initial power switch (S1, S4) with the initial power switch (S2, S3) already closed
- closing of the second power switch (S5, S6) switched in parallel with the closed initial power switches (S1, S2; S3, S4) following a time delay which is short in relation to the duration of the switch contact
- opening of the second power switch (S5, S6) switched in parallel with the closed initial power switches (S1, S2; S3, S4) shortly before the ending of the switch contact duration
- opening of the further initial power switch (S1, S4) switched in series connecting the bridge output (BA) with the centre potential (U_ZK/2) via the initial power switch (S2,S3) following a time delay which is short in relation to the duration of the switch contact.

## Revendications

1. Topologie de commutation pour un raccordement sur phase (PA) d'un onduleur avec un pont de commutation, dont la sortie de pont (BA) peut être reliée à au moins un potentiel limite supérieur (U_ZK+) et à un potentiel limite inférieur (U_ZK-) par l'intermédiaire d'une moitié de demi-pont respectivement supérieure et inférieure comprenant au moins deux premiers commutateurs de puissance (S1, S2; S3, S4) connectés en série, ainsi que, par l'intermédiaire d'une diode respective (D1, D2) et d'un premier commutateur de puissance (S2, S3) de la moitié de demi-pont supérieure ou inférieure, qui est connecté en série avec elle, à un potentiel moyen (U_ZK/2), situé entre le potentiel limite supérieur et un potentiel limite inférieur, **caractérisée en ce que**
la moitié de demi-pont supérieure et la moitié de demi-pont inférieure comprennent chacune au moins un autre deuxième commutateur de puissance (S5, S6), qui est respectivement connecté en parallèle par rapport au circuit en série des premiers commutateurs de puissance (S1, S2; S3, S4).

2. Topologie de commutation selon la revendication 1, **caractérisée en ce que** le pont de commutation comprend d'autres premiers commutateurs de puissance et des diodes par l'intermédiaire desquels la sortie de pont (BA) peut être reliée à des potentiels intermédiaires, qui sont situés entre le potentiel moyen (U_ZK/2) et le potentiel limite supérieur (U_ZK+) et le potentiel limite inférieur (U_ZK-).

3. Topologie de commutation selon revendication 1 ou 2, **caractérisée en ce que** les premiers commutateurs de puissance (S1, S2; S3, S4) connectés en série sont conçus dans le but d'obtenir des pertes de commutation aussi faibles que possible et que les deuxième commutateurs de puissance (S5, S6), respectivement connectés par rapport au circuit en série des premiers commutateurs de puissance (S1, S2; S3, S4), sont conçus dans le but d'obtenir des tensions de saturation aussi faibles que possible.

4. Procédé de génération une tension de sortie de phase d'un onduleur avec une topologie de commutation selon l'une des revendications précédentes, sachant que le déroulement d'un cycle de commutation, au début et à la fin duquel la sortie de pont (BA) est reliée au potentiel moyen (U_ZK/2) respectivement par l'intermédiaire d'une diode (D1, D2) et d'un premier commutateur de puissance (S2, S3) connecté en série avec celle-ci, est **caractérisé par** les étapes de procédé:
- Fermeture de l'autre premier commutateur de puissance (S1, S4), connecté en série par rapport au premier commutateur de puissance (S2, S3) déjà fermé,
- Fermeture de l'autre deuxième commutateur de puissance (S5, S6), connecté en parallèle par rapport aux premiers commutateurs de puissance (S1, S2; S3, S4) fermés,
- Ouverture, peu avant l'écoulement de la durée du cycle de commutation, du deuxième commutateur de puissance (S5, S6) connecté en parallèle par rapport au premier commutateur de puissance (S1, S2; S3, S4) fermé,
- Ouverture de l'autre premier commutateur de puissance (S1, S4), connecté en série avec le premier commutateur de puissance (S2, S3), qui relie la sortie de pont (BA) au potentiel moyen (U_ZK/2), après un court temps de retardement par rapport à la durée du cycle de commutation.
